# EUROPÄISCHE PATENTANMELDUNG

(11) **EP 2 020 825 A2**
(43) Veröffentlichungstag der Anmeldung: **04.02.2009**
(21) Anmeldenummer: 08161570.0
(22) Anmeldetag: 31.07.2008
(51) Int. Cl.: H05B 3/14

(54) **Widerstandsheizer und Verfahren zum Herstellen desselben**

(30) Priorität: 31.07.2007 DE 102007035856
(71) Anmelder: Sintec Keramik GmbH, 86956 Schongau (DE)
(72) Erfinder: Nürnberger, Michael, 93055 Regensburg (DE)
(74) Vertreter: Viering, Jentschura & Partner

(57) **Zusammenfassung**

Elektrisch leitfähiger Widerstandsheizer, der als Sinterkörper mit einer Gesamtporosität von größer gleich 20 Vol.-% ausgebildet ist und eine Mischung aus einer körnigen, elektrisch leitfähigen Komponente, die aus der Gruppe ausgewählt ist, die aus Boriden, Nitriden und Carbiden von jeweils der IV., V. und VI. Nebengruppe und einer Mischung aus wenigstens zwei dieser Verbindungen besteht, und einem körnigen, hochschmelzenden Oxid in einem niedrigschmelzenden Oxid und/oder Borat als Bindephase aufweist.

## Beschreibung

Die Erfindung betrifft einen elektrisch leitfähigen Widerstandsheizer und ein Verfahren zum Herstellen desselben. Der erfindungsgemäße Widerstandsheizer kann z.B. als Heizelement, beispielsweise in Form einer Heizwendel, in einem Ofen eingesetzt werden oder Bestandteil eines Verdampferschiffchens zum Verdampfen von Metall gemäß der PVD-Technik sein.

Das gebräuchliche Verfahren zum Beschichten von flexiblen Substraten mit Metallen ist das sog. Vakuum-Bandmetallisieren gemäß der PVD (physical vapor deposition)-Technik. Als flexible Substrate kommen z.B. Papier, Kunststofffolien und Textilien in Frage, und als Metall wird überwiegend Aluminium eingesetzt. So beschichtete Substrate finden breite Anwendung für Verpackungs-, Dekorationszwecke, bei der Kondensatorherstellung und in der Umwelttechnik (Isolation).

Die Beschichtung der flexiblen Substrate erfolgt in sog. Metallisierungsanlagen. In der Metallisierungsanlage wird das zu beschichtende Substrat über eine gekühlte Walze geführt und dabei einem Metalldampf ausgesetzt, der sich auf der Substratoberfläche als dünne Metallschicht niederschlägt. Zur Erzeugung des erforderlichen konstanten Dampfstromes werden widerstandsbeheizte Verdampferkörper, z.B. in Form sogenannter Verdampferschiffchen, eingesetzt, die im direkten Stromdurchgang auf z.B. 1450-1600°C erhitzt werden. Metalldraht wird kontinuierlich zugeführt, auf der Oberfläche der Verdampferschiffchen verflüssigt und im Vakuum bei ca. 10⁻⁴ mbar verdampft. Als Metall wird hauptsächlich Aluminium eingesetzt.

Nicht flexible Substrate werden gemäß der PVD-Technik z.B. batchweise in einem diskontinuierlichen Prozess, z.B. mittels Flash-Verdampfung, beschichtet. Nicht flexible Substrate sind z.B. Fernsehbildschirme und Kunststoffteile.

Derartige Verdampferkörper bestehen in der Regel aus heißgepreßtem keramischem Material, das als Hauptkomponente Titandiborid und Bornitrid und/oder Aluminiumnitrid enthält. Titandiborid ist dabei die elektrisch leitfähige Komponente und Bornitrid und/oder Aluminiumnitrid sind die elektrisch isolierende Komponente, die miteinander gemischt zu spezifischen Heiß-Widerständen von 600-6000 µOhm*cm führen, wobei ein Mischungsverhältnis von leitfähiger zu nichtleitfähiger Komponente von je 50 Gew% (+/- 10 Gew%) vorliegt.

Flüssiges Aluminium verursacht während des Metallisierungsprozesses auf dem Verdampferschiffchen Korrosion und Erosion, wodurch die nutzbare Lebensdauer des Verdampferschiffchens begrenzt wird. Auswaschungen von tiefen Gräben in der Umgebung des Aluminium-Drahtauftreffpunktes und Schwierigkeiten bei der Kontrolle der optimalen Temperaturverteilung über die Verdampferoberfläche während des Metallisierens sind typische Ausfallgründe. Weiterhin stellt die Benetzung, vor allem die Erstbenetzung, der Verdampferschiffchen mit dem zu verdampfenden Metall ein Problem dar. Von der Benetzungsfähigkeit des zu verdampfenden Metalls wird auch die maximale Abdampfrate (kg Metall pro Zeiteinheit) beeinflusst.

Ferner besteht das Problem, dass sich die Leitfähigkeit des insgesamt leitfähigen Verdampferkörpers durch das damit in Kontakt stehende, zu verdampfende Metall ändert, und zwar unregelmäßig je nach Menge und Ausdehnung an zugeführtem und abgedampftem Metall. Hierdurch ist es notwendig, die Stromzufuhr an den Verdampferkörper stets entsprechend nachzuregeln, um eine gleichmäßige Abdampfrate beibehalten zu können. Ferner kann es durch den Stromfluss durch das auf der Verdampferfläche vorliegende Metallbad zu Wärmekonzentrationen kommen, vor allem an den Enden des Verdampferkörpers, an denen die Stromzufuhr erfolgt, wodurch der Verdampferkörper schneller korrodiert und damit schneller verschleißt.

Daher wird im Stand der Technik auf den Verdampferkörper häufig eine Schichtstruktur aufgebracht, auf welche das Metall zugeführt wird, um Korrosion und Erosion des Verdampferkörpers weitgehend zu vermeiden und dadurch die Lebensdauer des Verdampferkörpers zu erhöhen und die Benetzbarkeit je nach dem verwendeten Metall zu fördern. Zum Beispiel wird in der US 4,264,803 ein Verdampferschiffchen vorgeschlagen, das einen elektrisch leitfähigen Kern aus einem Graphitmaterial aufweist, der mit elektrisch isolierendem Bornitrid beschichtet ist. Durch die mit der Bornitridschicht erreichte elektrische Isolierung des elektrischen Graphitkerns wird die Leitfähigkeit des Graphitmaterials durch das auf die Bornitridschicht aufgetragene Metall nicht mehr beeinflusst. Die Verwendung eines derartigen Verdampferschiffchens bringt jedoch Probleme hinsichtlich der korrekten Wärmeübertragung von dem Graphitmaterial zu der Bornitridbeschichtung sowie aus der unterschiedlichen Wärmedehnung der Materialen resultierende Probleme mit sich, die zu Abplatzungen der Bornitridbeschichtung führen können. Die via CVD-Verfahren (Chemical Vapor Deposition) aufgebrachte Beschichtung ist ferner hoch anisotrop, was ein sehr schlechtes Wärmeleitverhalten in Dickenrichtung der Beschichtung mit sich bringt.

Eine Alternative zu den Verdampferschiffchen mit elektrisch leitfähigem Kern und darauf aufgebrachter isolierender Schicht sind Verdampferschiffchen mit einem elektrisch leitfähigen Heizteil/Verdampferkörper-Kernteil und einem elektrisch isolierenden Verdampferkörper-Außenteil, das das Kernteil aufnimmt/umhüllt.

Zum Beispiel ist aus der US 3 515 852 und der US 3 514 575 jeweils ein aus einem Verdampferkörper-Kernteil und einem Verdampferkörper-Außenteil bestehender Verdampferkörper bekannt, wobei das Verdampferkörper-Außenteil aus Bornitrid hergestellt ist, und wobei das Verdampferkörper-Kernteil aus ineinander verschachtelten Drahtwendeln aus einem Refraktärmetall besteht.

Ferner sind in der nicht vorveröffentlichten deutschen Patentanmeldung mit dem Aktenzeichen DE 10 2006 001 855.9 und in der ebenfalls nicht vorveröffentlichten Patentanmeldung mit dem Aktenzeichen PCT/DE2007/000032, deren gesamter Inhalt jeweils durch Bezugnahme hierin aufgenommen ist, ein Verdampferkörper aus einem Verdampferkörper-Außenteil und einem plattenförmigen Verdampferkörper-Kernteil beschrieben, bei dem das Verdampferkörper-Kernteil in einem durchgehenden, inneren Hohlraum des Verdampferkörper-Außenteils mit Spiel aufgenommen ist und sich durch den Hohlraum hindurch erstreckt, wobei das Verdampferkörper-Kernteil einen größeren Wärmeausdehnungskoeffizienten hat als das Verdampferkörper-Außenteil, und wobei das Verdampferkörper-Kernteil bei Betriebstemperatur des Verdampferkörpers an der Wandung des Hohlraums ohne Spiel plan anliegt. Als Materialien für das Verdampferkörper-Kernteil sind in der DE 10 2006 001 855.9 Graphit, Graphitfolie, hochleitfähige Keramiken wie z. B. Titandiborid oder auch Refraktärmetalle wie z. B. Wolfram, Molybdän sowie Kombinationen davon genannt. Als Materialien für das Verdampferkörper-Außenteil sind Boride, Nitride und Oxide genannt, wie Bornitrid, Aluminiumnitrid, Zirkonoxid, Aluminiumoxid sowie deren Kombinationen.

Die Kenntnis des Stands der Technik bzgl. Heizelemente im Allgemeinen umfasst die marktüblichen, bekannten elektrischen Hochtemperatur-Widerstandheizer aus Graphit (auch CFC) oder hochschmelzenden Metallen und deren Legierungen (z.B. Mo, W, Ta) oder MoSi₂.

Die bisher bekannten Widerstandsheizer/Verdampferkörper-Kernteile sind jedoch entweder nicht beständig gegenüber dem Angriff von flüssigem Aluminium (Aluminiumspritzer oder überlaufendes Aluminium) und/oder sie reagieren beim Hochtemperatur-Einsatz mit dem umhüllenden Verdampferkörper, d.h. die chemische Beständigkeit (z.B. gegenüber Aluminium) ist bei den bekannten Widerstandsheizern nicht gegeben. Z.B. bilden Metalle mit Aluminium häufig Legierungen, und Graphit reagiert sowohl mit dem umhüllenden Verdampferkörper als auch mit dem flüssigen, zu verdampfenden Aluminium. MoSi₂-Heizer sind im Hochvakuum bei höheren Temperaturen (>1500°C) nicht beständig.

Weiterhin ist es schwierig mit den bekannten Widerstandsheizern/Verdampferkörper-Kernteilen genügend Heizenergie in die vorgegebene Verdampfergeometrie unter den vorgegebenen max. Strom- und Spannungswerten der am Markt befindlichen Metallisierungsanlagen zu überführen (Metalle und MoSi₂ sind zu niederohmig). Unter Berücksichtigung des vorgegebenen Strom-/Spannungsangebots können Metalle und MoSi₂ daher nur unter Verwendung von sehr kleinen Querschnitten verwendet werden - dann kann die nötige Heizenergie jedoch nicht ausreichend zugeführt werden. Graphit besitzt zwar einen geeigneten spezifischen elektrischen Widerstand, reagiert aber wie oben beschrieben mit dem umhüllenden Verdampferkörper sowie mit flüssigem Aluminium.

Ferner können die Härte/Festigkeit und der spezifische elektrische Widerstand bei den bekannten Widerstandsheizern nur in beschränktem Maße variiert/eingestellt werden, und komplizierte Bauteile sind in der Regel mit den bekannten Materialien und Verfahren nur schwer herzustellen.

Aus DE 600 12 053 T2 ist ein Keramikmaterial bekannt, aufweisend ein hochschmelzendes Oxid, welches mit einer elektrisch leitfähigen Komponente dotiert ist, und ein niedrigschmelzendes Oxid.

DE 100 04 177 A1 offenbart ein poröses elektrisches Heizelement, bei dem die Poren durch Beimischen von sich beim Sintern auflösenden Füllkörpern in das Ausgangsmaterial erzielt werden.

DE 1 040 874 B beschreibt einen unmittelbar widerstandsbeheizten Verdampfungstiegel aus einer keramischen Komponente, wie z.B. Aluminiumoxyd oder Zirkonoxyd, und einer metallischen Komponente, wie z.B. Titancarbid oder Wolframcarbid.

DE 32 39 949 C2 offenbart ein widerstandsbeheiztes Schiffchen zum Verdampfen von Metallen, mit einem Heizteil aus einem feuerfesten Material aus der Gruppe Metallkarbide, -boride, -nitride, -silicide, -oxide und Gemischen davon.

DE 195 16 233 C1 beschreibt ein beschichtetes Verdampferschiffchen.

Es ist ein Ziel der Erfindung, die oben genannten Nachteile zu vermeiden und einen Widerstandsheizer bereitzustellen, der eine verbesserte Beständigkeit (chemische und Hochtemperatur-Beständigkeit), ein gutes Temperaturwechselverhalten, eine zweckmäßige Festigkeit und einen zweckmäßigen spezifischen elektrischen Widerstand (unabhängig von der geforderten Form) aufweist. Ferner ist es ein Ziel der Erfindung ein Verfahren zu schaffen, mit dem auf einfache und effiziente Weise ein Widerstandsheizer hergestellt werden kann, der die oben genannten Eigenschaften aufweist, wobei das Verfahren auch dazu geeignet sein soll, Widerstandsheizer mit komplizierter Geometrie/Struktur herzustellen.

Hierzu stellt die Erfindung einen Widerstandsheizer gemäß Anspruch 1 oder Anspruch 2 sowie ein Verfahren zum Herstellen desselben gemäß Anspruch 8 bereit. Weitere Ausführungsformen des erfindungsgemäßen Widerstandsheizers und des erfindungsgemäßen Verfahrens sind in den abhängigen Ansprüchen 3 bis 5 bzw. 9 bis 15 beschrieben. Gemäß Anspruch 6 kann der erfindungsgemäße Widerstandsheizer z.B. als Verdampferkörper-Kernteil verwendet werden. Ein solches Verdampferkörper-Kernteil bildet zusammen mit einem Verdampferkörper-Außenteil einen Verdampferkörper gemäß Anspruch 7.

Der erfindungsgemäße Widerstandsheizer ist als Sinterkörper ausgebildet und hat eine Porosität von mindestens 20 Vol.-%. Aufgrund der Porosität und der in Anspruch 1 beschriebenen Materialzusammensetzung hat der erfindungsgemäße Verdampferkörper ein verbessertes Temperaturwechselverhalten sowie eine erhöhte Hochtemperatur-Beständigkeit. Ferner können der spezifische elektrische Widerstand und die Festigkeit des Widerstandsheizers durch geeignetes Einstellen von z.B. Art und/oder Menge und/oder Korngrößenverteilung der eingesetzten Komponenten (Ausgangskomponenten) sowie durch Einstellen des Sinterdrucks und/oder der Sintertemperatur und/oder der Grünlingsdichte auf einfache und dennoch effiziente Weise an die zweckmäßige Festigkeit bzw. den zweckmäßigen Widerstand bei gewünschter/geforderter Form angepasst werden. Da der Widerstandsheizer als Sinterkörper ausgebildet ist, kann er zudem auch in komplizierten Strukturen/Geometrien hergestellt werden.

Ferner hat der erfindungsgemäße Widerstandsheizer eine erhöhte chemische Beständigkeit z.B. gegenüber nichtoxidischen Substanzen wie Aluminium, wodurch er sich z.B. als Verdampferkörper-Kernteil zum Einsetzen in ein Verdampferkörper-Außenteil, welches aus einem elektrisch isolierenden Material hergestellt ist und einen an die Abmessungen des Kernteils angepassten durchgehenden inneren Hohlraum zur Aufnahme des Kernteils aufweist, unter Ausbildung eines Verdampferkörpers eignet. Als Material für das Verdampferkörper-Außenteil kann wie in der DE 10 2006 001 855.9 beschrieben z.B. ein Borid und/oder Nitrid und/oder Oxid eingesetzt werden, wie Bornitrid, Aluminiumnitrid, Zirkonoxid, Aluminiumoxid sowie eine Mischung aus wenigstens zwei dieser Komponenten. Zudem ist der Widerstandsheizer bzw. das durch diesen gebildete Verdampferkörper-Kernteil inert gegenüber dem Verdampferkörper-Außenteil. Wird der Widerstandsheizer als Verdampferkörper-Kernteil eingesetzt, kann er z.B. platten- oder stabförmig ausgebildet sein. Des Weiteren kann der erfindungsgemäße Widerstandsheizer aber auch ganz allgemein als ein Hochtemperatur-Heizelement verwendet werden, das z.B. unter Schutzgas oder Vakuum bis zu Temperaturen von beispielsweise 2100°C in einer Heizvorrichtung eingesetzt werden kann.

Der erfindungsgemäße Widerstandsheizer weist zumindest eine körnige, elektrisch leitfähige Komponente, ein körniges, hochschmelzendes Oxid und ein niedrigschmelzendes Oxid und/oder Borat auf. Die zumindest drei Komponenten liegen in Mischung vor, wobei das niedrigschmelzende Oxid und/oder Borat eine Bindephase bildet, und wobei die elektrisch leitfähigen Partikel und die hochschmelzenden Oxid-Partikel größtenteils reinrassig miteinander versintert sind und mit der jeweiligen anderen Komponente über die Bindephase verbunden sind. Die elektrisch leitfähige Komponente ist aus der Gruppe ausgewählt, die aus Boriden, Nitriden und Carbiden von jeweils der IV., V. und VI. Nebengruppe und einer Mischung aus wenigstens zwei dieser Verbindungen besteht. Zum Beispiel ist die elektrisch leitfähige Komponente TiB₂. Das hochschmelzende Oxid kann z.B. aus der Gruppe ausgewählt sein, die aus ZrO₂, Y₂O₃, MgO, CaO, CeO₂, Cr₂O₃, HfO₂ sowie einer Mischung aus wenigstens zwei dieser Verbindungen besteht. Zum Beispiel kann das hochschmelzende Oxid teil- oder vollstabilisiertes ZrO₂ sein, wobei der Stabilisator z.B. Y₂O₃, MgO oder CaO sein kann. Das niedrigschmelzende Oxid und/oder Borat kann z.B. aus der Gruppe ausgewählt sein, die aus (a) den Oxiden des Eisens, des Aluminiums, des Titans und des Siliziums sowie einer Mischung aus wenigstens zwei dieser Verbindungen, (b) den Mischoxiden der unter (a) genannten Oxide mit Al₂O₃ und/oder Y₂O₃ und/oder MgO und/oder CaO, (c) Kalziumborat sowie B₂O₃ in Verbindung mit zumindest einem der unter (a) und (b) genannten Oxide und Mischoxide und (d) einer Mischung aus wenigstens zwei der unter (a) bis (c) genannten Verbindungen besteht. Zum Beispiel kann der erfindungsgemäße Widerstandsheizer TiB₂-Pulver als elektrisch leitfähige Komponente, Y₂O₃-stabilisiertes ZrO₂-Pulver als hochschmelzendes Oxid und Fe₂O₃ und/oder Fe₃O₄ und/oder Yttriumaluminat und/oder MgO*Al₂O₃ und/oder Al₂O₃ und/oder Aluminiumtitanat und/oder eine Boratverbindung der genannten Verbindungen als Bindephase aufweisen.

Beispielsweise kann der Widerstandsheizer 40-60 Gew.-% der elektrisch leitfähigen Komponente, 40-60 Gew.-% des hochschmelzenden Oxids und weniger als 3 Gew.-% des niedrigschmelzenden Oxids und/oder Borats aufweisen.

Es kann beispielsweise vorgesehen sein, dass der Widerstandsheizer so ist, dass die Ausgangskomponente der elektrisch leitfähigen Komponente und/oder die Ausgangskomponente des hochschmelzenden Oxids eine trimodale Pulver-Korngrößenverteilung mit einer feinen Korngrößenfraktion mit einer durchschnittlichen Korngröße von 4-8 µm, einer mittleren Korngrößenfraktion mit einer durchschnittlichen Korngröße von 10-40 µm und einer groben Korngrößenfraktion mit einer durchschnittlichen Korngröße von 40-100 µm aufweisen.

Gemäß einer anderen Ausführungsform besteht der Widerstandsheizer aus der Mischung aus körniger, elektrisch

leitfähiger Komponente, körnigem, hochschmelzenden Oxid und niedrigschmelzendem Oxid und/oder Borat.

Die elektrisch leitfähige Komponente und das hochschmelzende Oxid sind zu jeweils 20-80 Gew.-%, zum Beispiel zu je 40-60 Gew.-%, in der Mischung enthalten und bilden somit die Hauptkomponenten. Der Anteil des niedrigschmelzenden Oxids und/oder Borats liegt bei weniger als 5 Gew.-%, z.B. bei weniger als 3 Gew.-%. Bei größeren Gewichtsanteilen des niedrigschmelzenden Oxids und/oder Borats kann eine Porosität von größer gleich 20 Vol.-% nur schwer erreicht werden.

Der spezifische elektrische Kaltwiderstand des erfindungsgemäßen Widerstandsheizers liegt z.B. in dem Bereich von 10 bis 20.000 µOhm*cm, z.B. in dem Bereich von 500 bis 4000 µohm*cm, z.B. in dem Bereich von 800 bis 2000 µOhm*cm. Das hochschmelzende Oxid kann in reiner Form (das heißt gesondert und nicht in der Mischung vorliegend) einen Schmelzpunkt von 2200°C oder mehr haben, und das niedrigschmelzende Oxid kann in reiner Form einen Schmelzpunkt von kleiner 2200°C haben, wobei sich in der Mischung durch das Zusammenwirken der unterschiedlichen Komponenten andere Schmelzpunkte ergeben können. Z.B. hat das niedrigschmelzende Oxid einen Schmelzpunkt von 1400-2200 °C, z.B. 1500-1800 °C, und das hochschmelzende Oxid einen Schmelzpunkt von 2200-3350 °C, z.B. 2500-2800 °C.

Der Widerstandsheizer wie er im Anspruch 1 oder 2 oder deren Unteransprüchen beschrieben und / oder entsprechend einem oder mehreren Beispielen der Beschreibung oder der Figuren weitergebildet ist, kann beispielsweise so sein, dass er einen spezifischen elektrischen Kaltwiderstand von 10 bis 20.000 µOhm*cm aufweist.

Der Widerstandsheizer wie er im Anspruch 1 oder 2 oder deren Unteransprüchen beschrieben und / oder entsprechend einem oder mehreren Beispielen der Beschreibung oder der Figuren weitergebildet ist, kann beispielsweise so sein, dass das hochschmelzende Oxid in reiner Form einen Schmelzpunkt von 2200°C oder mehr und das niedrigschmelzende Oxid in reiner Form einen Schmelzpunkt von kleiner 2200°C besitzt.

Der Widerstandsheizer wie er im Anspruch 1 oder 2 oder deren Unteransprüchen beschrieben und / oder entsprechend einem oder mehreren Beispielen der Beschreibung oder der Figuren weitergebildet ist, kann beispielsweise so sein, dass die elektrisch leitfähige Komponente TiB₂ ist.

Der Widerstandsheizer wie er im Anspruch 1 oder 2 oder deren Unteransprüchen beschrieben und / oder entsprechend einem oder mehreren Beispielen der Beschreibung oder der Figuren weitergebildet ist, kann beispielsweise so sein, dass das hochschmelzende Oxid aus der Gruppe ausgewählt ist, die aus ZrO₂, Y₂O₃, MgO, CaO, CeO₂, Cr₂O₃, HfO₂ sowie einer Mischung aus wenigstens zwei dieser Verbindungen besteht.

Der Widerstandsheizer wie er im Anspruch 1 oder 2 oder deren Unteransprüchen beschrieben und / oder entsprechend einem oder mehreren Beispielen der Beschreibung oder der Figuren weitergebildet ist, kann beispielsweise so sein, dass das hochschmelzende Oxid teil- oder vollstabilisiertes ZrO₂ ist.

Dabei kann vorgesehen sein, dass das hochschmelzende Oxid mit Y₂O₃, MgO oder CaO teil- oder vollstabilisiertes ZrO₂ ist.

Die Ausgangskomponente der elektrisch leitfähigen Komponente und/oder die Ausgangskomponente des hochschmelzenden Oxids weisen eine zumindest bimodale, z.B. eine trimodale, Pulver-Korngrößenverteilung mit zumindest einer Korngrößenfraktion mit einer mittleren Korngröße von größer gleich 15 µm auf. Zum Beispiel weist die Ausgangskomponente der elektrisch leitfähigen Komponente und/oder die Ausgangskomponente des hochschmelzenden Oxids eine trimodale Pulver-Korngrößenverteilung mit einer feinen Korngrößenfraktion mit einer durchschnittlichen Korngröße von 4-8 µm, einer mittleren Korngrößenfraktion mit einer durchschnittlichen Korngröße von 10-40 µm und einer groben Korngrößenfraktion mit einer durchschnittlichen Korngröße von 40-100 µm auf. Eine zumindest bimodale Korngrößenverteilung von zumindest einer der beiden Ausgangs-Hauptkomponenten begünstigt die Ausbildung einer optimierten Porenstruktur in dem gesinterten Widerstandsheizer bei zweckmäßiger Festigkeit des Widerstandheizers, woraus u. a. auch ein verbessertes Temperaturwechselverhalten resultiert.

Zur Herstellung des porösen, elektrisch leitfähigen Widerstandsheizers wird zunächst aus einer Pulvermischung aus mindestens drei unterschiedlichen Komponenten ein Grünling geformt, der anschließend bei geringem Sinterdruck (maximaler Sinterdruck = 20 bar) oder drucklos bei z.B. etwa 2000°C gesintert wird. Für die Pulvermischung wird dabei eine körnige, elektrisch leitfähige Komponente, die aus der Gruppe ausgewählt ist, die aus Boriden, Nitriden und Carbiden von jeweils der IV., V. und VI. Nebengruppe und einer Mischung aus wenigstens zwei dieser Verbindungen besteht, ein körniges, hochschmelzendes Oxid und ein körniges, niedrigschmelzendes Oxid und/oder Borat verwendet.

Wird beispielsweise für die elektrisch leitfähige Komponente TiB₂ und für das niedrigschmelzende Oxid und/oder Borat ein niedrigschmelzendes Oxid eingesetzt, kann es zu einer Reaktion zwischen dem niedrigschmelzenden Oxid und B₂O₃, welches eine übliche Verunreinigung des TiB₂ ist, zu dem entsprechenden Borat kommen. Wird z.B. Kalziumoxid als niedrigschmelzendes Oxid eingesetzt, kann es zu einer Reaktion zwischen CaO und B₂O₃ zu Kalziumborat kommen, so dass in der Bindephase je nach eingesetzter CaO-Menge Kalziumborat und (nicht reagiertes) Kalziumoxid vorliegen kann.

Der Grünling kann z.B. in einem plastischen Formgebungsverfahren oder einem Schlickergießprozess oder einem Trockenpressprozess oder durch Pressen einer Krümelmasse, die neben der Pulvermischung Wasser und Bindemittel aufweist, geformt werden, wobei die Grünlingsdichte z.B. auf 40 bis 60% der Dichte des gesinterten Widerstandsheizers eingestellt wird.

Durch geeignetes Einstellen der Grünlingsdichte und des Sinterdrucks ist es möglich, die Gesamtporosität und Porenstruktur des Sinterkörpers gezielt zu beeinflussen/steuern. Des Weiteren können die Porenstruktur und die Gesamtporosität des Widerstandsheizers/Sinterkörpers über das Mischungsverhältnis der unterschiedlichen Komponenten und/oder die Korngrößenverteilung der Pulvermischung an die gewünschte Struktur angepasst bzw. auf den gewünschten Wert, d.h. auf einen Wert von größer gleich 20 Vol.-%, eingestellt werden.

Ebenso kann über den Sinterdruck und/oder das Mischungsverhältnis der unterschiedlichen Komponenten und/oder die Korngrößenverteilung der Pulvermischung und/oder die Grünlingsdichte der spezifische elektrische Kaltwiderstand des Widerstandsheizers auf den gewünschten Wert, z.B. auf 10 bis 20000 µOhm*cm, eingestellt werden.

Das Verfahren wie es im Anspruch 8 oder dessen Unteransprüchen beschrieben und / oder entsprechend einem oder mehreren Beispielen der Beschreibung oder der Figuren weitergebildet ist, kann beispielsweise so sein, dass das Mischungsverhältnis der unterschiedlichen Komponenten und/oder die Korngrößenverteilung der Pulvermischung und/oder die Grünlingsdichte derart eingestellt werden, dass nach dem Sinterprozess der spezifische elektrische Kaltwiderstand des Widerstandsheizers 10 bis 20000 µOhm*cm ist.

Das Verfahren wie es im Anspruch 8 oder dessen Unteransprüchen beschrieben und / oder entsprechend einem oder mehreren Beispielen der Beschreibung oder der Figuren weitergebildet ist, kann beispielsweise so sein, dass für die elektrisch leitfähige Komponente TiB₂ verwendet wird.

Das Verfahren wie es im Anspruch 8 oder dessen Unteransprüchen beschrieben und / oder entsprechend einem oder mehreren Beispielen der Beschreibung oder der Figuren weitergebildet ist, kann beispielsweise so sein, dass das hochschmelzende Oxid aus der Gruppe ausgewählt wird, die aus ZrO₂, Y₂O₃, MgO, CaO, CeO₂, Cr₂O₃, HfO₂ sowie einer Mischung aus wenigstens zwei dieser Komponenten besteht.

Das Verfahren wie es im Anspruch 8 oder dessen Unteransprüchen beschrieben und / oder entsprechend einem oder mehreren Beispielen der Beschreibung oder der Figuren weitergebildet ist, kann beispielsweise so sein, dass für das hochschmelzende Oxid teil- oder vollstabilisiertes ZrO₂ verwendet wird.

Das Verfahren wie es im Anspruch 8 oder dessen Unteransprüchen beschrieben und / oder entsprechend einem oder mehreren Beispielen der Beschreibung oder der Figuren weitergebildet ist, kann beispielsweise so sein, dass für das hochschmelzende Oxid mit Y₂O₃, MgO oder CaO teil- oder vollstabilisiertes ZrO₂ verwendet wird.

Gemäß einem ersten, weiteren Aspekt wird ferner ein elektrisch leitfähiger Widerstandsheizer vorgeschlagen, der als Sinterkörper mit einer Gesamtporosität von größer gleich 20 Vol.-% ausgebildet ist und eine Mischung aus einer körnigen, elektrisch leitfähigen Komponente, die aus der Gruppe ausgewählt ist, die aus Boriden, Nitriden und Carbiden von jeweils der IV., V. und VI. Nebengruppe sowie einer Mischung aus wenigstens zwei dieser Verbindungen besteht, und einem körnigen, hochschmelzenden Oxid in einem niedrigschmelzenden Oxid und/oder Borat als Bindephase aufweist.

Gemäß einem zweiten, weiteren Aspekt wird ferner ein elektrisch leitfähiger Widerstandsheizer vorgeschlagen, der als Sinterkörper mit einer Gesamtporosität von größer gleich 20 Vol.-% ausgebildet ist, herstellbar durch Sintern eines Grünlings aus einer Pulvermischung, die eine körnige, elektrisch leitfähige Komponente, die aus der Gruppe ausgewählt ist, die aus Boriden, Nitriden und Carbiden von jeweils der IV., V. und VI. Nebengruppe sowie einer Mischung aus wenigstens zwei dieser Verbindungen besteht, ein körniges, hochschmelzendes Oxid, körniges Aluminiumnitrid und ein körniges, niedrigschmelzendes Oxid und/oder Borat aufweist, wobei der Grünling drucklos oder bei geringem Sinterdruck gesintert wird.

Beispielweise kann der Widerstandsheizer gemäß dem ersten, weiteren Aspekt oder der Widerstandsheizer gemäß dem zweiten, weiteren Aspekt ferner mit einem spezifischen elektrischen Kaltwiderstand von 10 bis 20.000 µOhm*cm gestaltet sein.

Beispielweise kann der Widerstandsheizer gemäß dem ersten, weiteren Aspekt oder der Widerstandsheizer gemäß dem zweiten, weiteren Aspekt bzw. der gemäß dem vorstehenden Beispiel weitergebildete Widerstandsheizer gemäß dem ersten, weiteren Aspekt oder der gemäß dem vorstehenden Beispiel weitergebildete Widerstandsheizer gemäß dem zweiten, weiteren Aspekt ferner so sein, dass das hochschmelzende Oxid in reiner Form einen Schmelzpunkt von 2200°C oder mehr und das niedrigschmelzende Oxid in reiner Form einen Schmelzpunkt von kleiner 2200°C besitzt.

Beispielweise kann der Widerstandsheizer gemäß dem ersten, weiteren Aspekt oder der Widerstandsheizer gemäß dem zweiten, weiteren Aspekt bzw. der gemäß diesem ersten oder diesem zweiten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner so sein, dass die elektrisch leitfähige Komponente TiB₂ ist.

Beispielweise kann der Widerstandsheizer gemäß dem ersten, weiteren Aspekt oder der Widerstandsheizer gemäß dem zweiten, weiteren Aspekt bzw. der gemäß diesem ersten oder diesem zweiten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner so sein, dass das hochschmelzende Oxid aus der Gruppe ausgewählt ist, die aus ZrO₂, Y₂O₃, MgO, CaO, CeO₂, Cr₂O₃, HfO₂ sowie einer Mischung aus wenigstens zwei dieser Verbindungen besteht.

Beispielweise kann der Widerstandsheizer gemäß dem ersten, weiteren Aspekt oder der Widerstandsheizer gemäß dem zweiten, weiteren Aspekt bzw. der gemäß diesem ersten oder diesem zweiten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner so sein, dass das hochschmelzende Oxid teil- oder vollstabilisiertes ZrO₂ ist.

Beispielweise kann der Widerstandsheizer gemäß dem ersten, weiteren Aspekt oder der Widerstandsheizer gemäß dem zweiten, weiteren Aspekt bzw. der gemäß diesem ersten oder diesem zweiten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner so sein, dass das hochschmelzende Oxid mit Y₂O₃, MgO oder CaO teil- oder vollstabilisiertes ZrO₂ ist.

Beispielweise kann der Widerstandsheizer gemäß dem ersten, weiteren Aspekt oder der Widerstandsheizer gemäß dem zweiten, weiteren Aspekt bzw. der gemäß diesem ersten oder diesem zweiten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner so sein, dass das niedrigschmelzende Oxid und/oder Borat aus der Gruppe ausgewählt ist, die besteht aus:
(a) den Oxiden des Eisens, des Aluminiums, des Titans und des Siliziums sowie einer Mischung aus wenigstens zwei dieser Verbindungen,
(b) den Mischoxiden der unter (a) genannten Oxide mit Al₂O₃ und/oder Y₂O₃ und/oder MgO und/oder CaO,
(c) Kalziumborat sowie B₂O₃ in Verbindung mit zumindest einem der unter (a) und (b) genannten Oxide und Mischoxide und
(d) einer Mischung aus wenigstens zwei der unter (a) bis (c) genannten Verbindungen.

Beispielweise kann der Widerstandsheizer gemäß dem ersten, weiteren Aspekt bzw. der gemäß diesem ersten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner 20-80 Gew.-% der elektrisch leitfähigen Komponente, 20-80 Gew.-% des hochschmelzenden Oxids und weniger als 5 Gew.-% des niedrigschmelzenden Oxids und/oder Borats aufweisen.

Beispielsweise kann der Widerstandsheizer dabei 40-60 Gew.-% der elektrisch leitfähigen Komponente, 40-60 Gew.-% des hochschmelzenden Oxids und weniger als 3 Gew.-% des niedrigschmelzenden Oxids und/oder Borats aufweisen.

Beispielweise kann der Widerstandsheizer gemäß dem ersten, weiteren Aspekt oder der Widerstandsheizer gemäß dem zweiten, weiteren Aspekt bzw. der gemäß diesem ersten oder diesem zweiten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner so sein, dasszumindest eine der Ausgangskomponenten der elektrisch leitfähigen Komponente und des hochschmelzenden Oxids Partikel mit einer Korngröße von größer gleich 15 µm aufweist.

Beispielweise kann der Widerstandsheizer gemäß dem ersten, weiteren Aspekt oder der Widerstandsheizer gemäß dem zweiten, weiteren Aspekt bzw. der gemäß diesem ersten oder diesem zweiten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner so sein, dass die Ausgangskomponente der elektrisch leitfähigen Komponente und/oder die Ausgangskomponente des hochschmelzenden Oxids eine zumindest bimodale, z.B. eine trimodale, Pulver-Korngrößenverteilung mit zumindest einer Korngrößenfraktion mit einer mittleren Korngröße von größer gleich 15 µm aufweisen.

Beispielweise kann der Widerstandsheizer gemäß dem ersten, weiteren Aspekt oder der Widerstandsheizer gemäß dem zweiten, weiteren Aspekt bzw. der gemäß diesem ersten oder diesem zweiten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner so sein, dass die Ausgangskomponente der elektrisch leitfähigen Komponente und/oder die Ausgangskomponente des hochschmelzenden Oxids eine trimodale Pulver-Korngrößenverteilung mit einer feinen Korngrößenfraktion mit einer durchschnittlichen Korngröße von 4-8 µm, einer mittleren Korngrößenfraktion mit einer durchschnittlichen Korngröße von 10-40 µm und einer groben Korngrößenfraktion mit einer durchschnittlichen Korngröße von 40-100 µm aufweisen.

Beispielweise kann der Widerstandsheizer gemäß dem ersten, weiteren Aspekt bzw. der gemäß diesem ersten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner so sein, dass er TiB₂-Partikel als elektrisch leitfähige Komponente und Y₂O₃-stabilisierte ZrO₂-Partikel als hochschmelzendes Oxid aufweist, wobei die Bindephase Fe₂O₃ und/oder Fe₃O₄ und/oder Yttriumaluminat und/oder MgO*Al₂O₃ und/oder Al₂O₃ und/oder Aluminiumtitanat und/oder eine Boratverbindung der genannten Verbindungen aufweist.

Beispielweise kann der Widerstandsheizer gemäß dem ersten, weiteren Aspekt oder der Widerstandsheizer gemäß dem zweiten, weiteren Aspekt bzw. der gemäß diesem ersten oder diesem zweiten weiteren Aspekt gemäß einem der vorstehenden Beispiele weitergebildete Widerstandsheizer oder gemäß einer beliebigen Kombination dieser vorstehenden Beispiele weitergebildete Widerstandsheizer ferner so sein, dass der Widerstandsheizer als Platten- oder Stabkörper ausgebildet ist.

Der gemäß diesem letztgenannten Beispiel ausgebildete Widerstandsheizer kann beispielsweise als Verdampferkörper-Kernteil verwendet werden, das in ein Verdampferkörper-Außenteil einsetzbar ist, welches aus einem elektrisch isolierenden Material hergestellt ist und einen inneren, durchgehenden Hohlraum zur Aufnahme des Verdampferkörper-Kernteils sowie eine Abdampffläche aufweist, von der aus ein darauf zugeführtes Metall verdampfbar ist.

Gemäß einem dritten, weiteren Aspekt wird ferner ein Verdampferkörper für den Betrieb in einer PVD-Metallisierungsanlage vorgeschlagen, mit
einem Verdampferkörper-Außenteil, das aus einem elektrisch isolierenden Material hergestellt ist und einen inneren, durchgehenden Hohlraum mit einer Begrenzungswand hat, auf deren Außenseite eine Abdampffläche ausgebildet ist, von welcher aus ein darauf zugeführtes Metall verdampfbar ist, und
einem Verdampferkörper-Kernteil, das als Widerstandsheizer gemäß Anspruch 16 ausgebildet ist und in den inneren Hohlraum des Verdampferkörper-Außenteils einsetzbar ist.

Gemäß einem dritten, weiteren Aspekt wird ferner ein Verfahren zum Herstellen eines porösen, elektrisch leitfähigen Widerstandsheizers vorgeschlagen, wobei bei dem Verfahren ein Grünling aus einer Pulvermischung aus mindestens drei unterschiedlichen Komponenten geformt und bei geringem Sinterdruck oder drucklos gesintert wird, und wobei für die Pulvermischung eine körnige, elektrisch leitfähige Komponente, die aus der Gruppe ausgewählt ist, die aus Boriden, Nitriden und Carbiden von jeweils der IV., V. und VI. Nebengruppe sowie einer Mischung aus wenigstens zwei dieser Verbindungen besteht, ein körniges, hochschmelzendes Oxid und ein körniges, niedrigschmelzendes Oxid und/oder Borat verwendet werden.

Beispielweise kann das Verfahren gemäß dem vierten, weiteren Aspekt ferner so sein, dass der Grünling in einem plastischen Formgebungsverfahren oder einem Schlickergießprozess oder einem Trockenpressprozess oder durch Pressen einer Krümelmasse, die neben der Pulvermischung Wasser und Bindemittel aufweist, geformt wird.

Beispielweise kann das Verfahren gemäß dem vierten, weiteren Aspekt bzw. das gemäß diesem vierten weiteren Aspekt gemäß dem vorstehenden Beispiel weitergebildete Verfahren ferner so sein, dass die Grünlingsdichte auf 40 bis 60% der Dichte des gesinterten Widerstandsheizers eingestellt wird.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass das Mischungsverhältnis der unterschiedlichen Komponenten und/oder die Korngrößenverteilung der Pulvermischung und/oder die Grünlingsdichte derart eingestellt werden, dass nach dem Sinterprozess die Gesamtporosität des Widerstandsheizers größer gleich 20 Vol.-% ist.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass das Mischungsverhältnis der unterschiedlichen Komponenten und/oder die Korngrößenverteilung der Pulvermischung und/oder die Grünlingsdichte derart eingestellt werden, dass nach dem Sinterprozess der spezifische elektrische Kaltwiderstand des Widerstandsheizers 10 bis 20000 µOhm*cm ist.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass für die elektrisch leitfähige Komponente TiB₂ verwendet wird.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass das hochschmelzende Oxid aus der Gruppe ausgewählt wird, die aus ZrO₂, Y₂O₃, MgO, CaO, CeO₂, Cr₂O₃, HfO₂ sowie einer Mischung aus wenigstens zwei dieser Komponenten besteht.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass für das hochschmelzende Oxid teil- oder vollstabilisiertes ZrO₂ verwendet wird.

Dabei kann beispielsweise für das hochschmelzende Oxid mit Y₂O₃, MgO oder CaO teil- oder vollstabilisiertes ZrO₂ verwendet werden.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass das hochschmelzende Oxid in einer Mischung mit Aluminiumnitrid bereitgestellt wird.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass das niedrigschmelzende Oxid und/oder Borat aus der Gruppe ausgewählt wird, die besteht aus:
(a) den Oxiden des Eisens, des Aluminiums, des Titans und des Siliziums sowie einer Mischung aus wenigstens zwei dieser Komponenten,
(b) den Mischoxiden der unter (a) genannten Oxide mit Al₂O₃ und/oder Y₂O₃ und/oder MgO und/oder CaO,
(c) Kalziumborat sowie B₂O₃ in Verbindung mit zumindest einem der unter (a) und (b) genannten Oxide und Mischoxide und
(d) einer Mischung aus wenigstens zwei der unter (a) bis (c) genannten Verbindungen.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass für die Mischung 20-80 Gew.-% der elektrisch leitfähigen Komponente, 20-80 Gew.-% des hochschmelzenden Oxids und weniger als 5 Gew.-% des niedrigschmelzenden Oxids und/oder Borats verwendet wird.

Dabei kann beispielweise für die Mischung 40-60 Gew.-% der elektrisch leitfähigen Komponente, 40-60 Gew.-% des hochschmelzenden Oxids und weniger als 3 Gew.-% des niedrigschmelzenden Oxids und/oder Borats verwendet werden.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass für die elektrisch leitfähige Komponente und/oder das hochschmelzende Oxid ein Pulver verwendet wird, das Partikel mit einer Korngröße von größer gleich 15 µm aufweist.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass für die elektrisch leitfähige Komponente und/oder das hochschmelzende Oxid ein Pulver verwendet wird, das eine zumindest bimodale, z.B. eine trimodale, Pulver-Korngrößenverteilung mit zumindest einer Korngrößenfraktion mit einer mittleren Korngröße von größer gleich 15 µm aufweist.

Dabei kann beispielsweise für die elektrisch leitfähige Komponente und/oder das hochschmelzende Oxid ein Pulver verwendet werden, das eine trimodale Pulver-Korngrößenverteilung mit einer feinen Korngrößenfraktion mit einer durchschnittlichen Korngröße von 4-8 µm, einer mittleren Korngrößenfraktion mit einer durchschnittlichen Korngröße von 10-40 µm und einer groben Korngrößenfraktion mit einer durchschnittlichen Korngröße von 40-100 µm aufweist.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass für das niedrigschmelzende Oxid und/oder Borat ein feinkörniges Pulver verwendet wird, das eine mittlere Korngröße von kleiner als 5 µm, z.B. kleiner als 3 µm, z.B. kleiner als 1 µm, hat.

Beispielweise kann das Verfahren gemäß dem vierten, weiteren Aspekt bzw. das gemäß diesem vierten weiteren Aspekt gemäß einem der vorstehenden Beispiele weitergebildete Verfahren oder gemäß einer beliebigen Kombination dieser vorstehenden Beispiele weitergebildete Verfahren ferner so sein, dass für die Mischung

TiB₂-Pulver als elektrisch leitfähige Komponente,
Y₂O₃-stabilisiertes ZrO₂-Pulver als hochschmelzendes Oxid und
Fe₂O₃ und/oder Fe₃O₄ und/oder Yttriumaluminat und/oder MgO*Al₂O₃ und/oder Al₂O₃ und/oder Aluminiumtitanat als niedrigschmelzendes Oxid und/oder Borat verwendet wird.

Die Erfindung wird im Folgenden anhand von Ausführungsbeispielen mit Bezugnahme auf die Zeichnung erläutert. In der Zeichnung zeigen:
Figur 1 eine Draufsicht auf einen Verdampferkörper gemäß einer ersten Ausführungsform der Erfindung, bestehend aus einem Verdampferkörper-Außenteil und einem als Verdampferkörper-Kernteil eingesetzten erfindungsgemäßen Widerstandsheizer,
Figur 2 einen Längsschnitt durch den Verdampferkörper aus Figur 1 bei Betriebstemperatur des Verdampferkörpers, d.h. im aufgeheizten Zustand,
Figur 3 eine Frontansicht des Verdampferkörpers aus Figur 1 vor dem Aufheizen des Verdampferkörpers, d.h. im kalten Zustand,
Figur 4a eine Querschnittsansicht eines Verdampferkörpers gemäß einer zweiten Ausführungsform der Erfindung vor dem Aufheizen des Verdampferkörpers,
Figur 4b eine Querschnittsansicht des Verdampferkörpers gemäß der zweiten Ausführungsform der Erfindung bei Betriebstemperatur des Verdampferkörpers und
die Figuren 5 bis 9 REM-Aufnahmen einer Bruchfläche eines erfindungsgemäßen Widerstandsheizers mit unterschiedlicher Vergrößerung (500x, 2000x, 5000x) und unterschiedlicher Aufnahmetechnik (BE und SE).

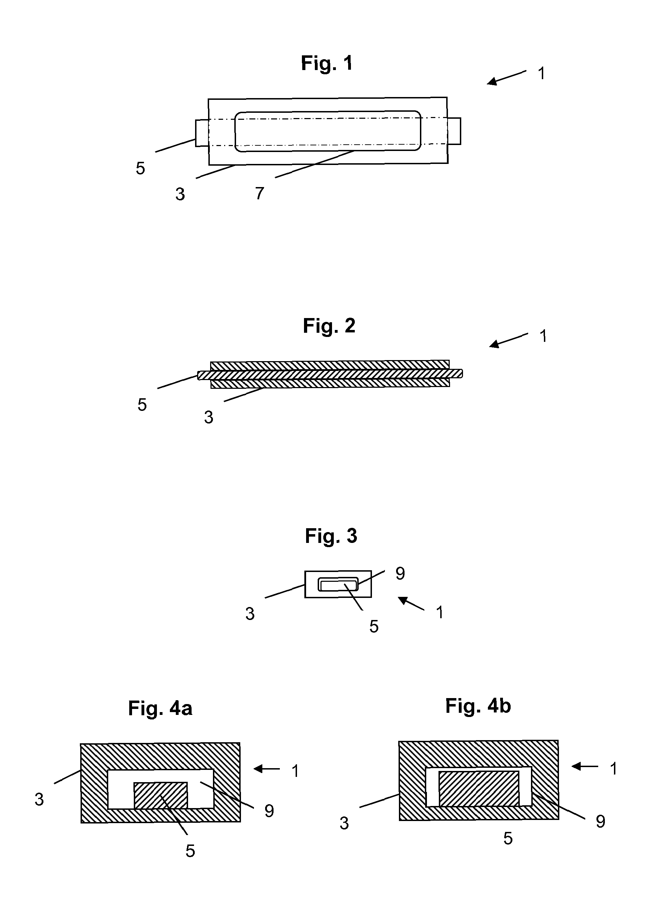

Wie in den Figuren 1 bis 3, 4a und 4b gezeigt, weist ein erfindungsgemäßer Verdampferkörper 1 ein Verdampferkörper-Außenteil 3 und ein Verdampferkörper-Kernteil 5 auf, welches in einem Hohlraum 9 aufgenommen ist, der in dem Verdampferkörper-Außenteil 3 ausgebildet ist. Das Verdampferkörper-Außenteil 3 kann zum Beispiel ein langgestreckter, quaderförmiger Plattenkörper aus gesintertem Bornitrid sein. Der Hohlraum 9 erstreckt sich in etwa zentral in dem Verdampferkörper-Außenteil 3, und zwar entlang dessen Längsrichtung durch das Verdampferkörper-Außenteil 3 komplett hindurch, wobei der Hohlraum 9 schlitzartig schmal ausgebildet ist.

Das Verdampferkörper-Kernteil 5 ist zum Beispiel ein einschichtiges, plattenförmiges oder stabförmiges Teil, welches im Querschnitt im Wesentlichen an den Querschnitt des Hohlraums 9 angepasst ist. Hierbei ist das Verdampferkörper-Kernteil 5 im kalten Zustand/bei Umgebungstemperatur, d.h. vor dem Aufheizen des Verdampferkörpers 1, hinsichtlich seiner Querschnittsabmessungen jedoch kleiner als der Hohlraum 9, so dass es mit Spiel in dem Hohlraum 9 lose aufgenommen ist (siehe Figuren 3 und 4a). Der Hohlraum 9 kann hierbei entsprechend dem Verdampferkörper-Außenteil 3 eine entsprechende Quaderform haben, wobei auch das Verdampferkörper-Kernteil 5 dann eine entsprechend langgestreckte quaderförmige Platte ist.

Das Verdampferkörper-Kernteil 5 kann außer an den Austrittsöffnungen des Hohlraums 9 komplett von dem Verdampferkörper-Außenteil 3 umschlossen sein, wobei das Verdampferkörper-Kernteil 5 an den Austrittsöffnungen des Hohlraums 7 jeweils axial etwas nach außen vorsteht, so dass es dort leichter an eine nicht dargestellte Stromversorgung anschließbar ist. Alternativ kann das Kernteil umfangsseitig klammerartig, d.h. nicht vollständig, von dem Außenteil umschlossen/umgeben sein, wobei dann die Platten-Unterseite des Kernteils teilweise frei liegt.

Auf einer Plattenseite (Plattenoberseite) des Verdampferkörper-Außenteils 3 (siehe Figur 1) ist eine Abdampffläche ausgebildet, in welcher nach der ersten Ausführungsform eine Kavität 7 ausgeformt ist. Abzudampfendes Metall wird in die Kavität 7 in flüssiger oder fester Form eingebracht, um von dort aus verdampft zu werden.

Die Beheizung des Verdampferkörpers 1 erfolgt mit Hilfe des Verdampferkörper-Kernteils 5, welches als Heizelement dient, das durch Hindurchleiten von elektrischem Strom widerstandsbeheizbar ist. Hierzu ist das Verdampferkörper-Kernteil 5 aus einem elektrisch leitfähigen Material hergestellt. Das Verdampferkörper-Außenteil 3 ist demgegenüber aus einem Material mit einem wesentlich höheren elektrischen Widerstand, so dass es relativ zu dem Verdampferkörper-Kernteil 5 als ein Isolator wirkt, von dem das auf die Abdampffläche aufgebrachte Metall von dem Verdampferkörper-Kernteil 3 elektrisch isoliert wird.

Gemäß der ersten Ausführungsform hat das Material des Verdampferkörper-Kernteils 5 einen größeren Wärmeausdehnungskoeffizienten als jenes des Verdampferkörper-Außenteils 3, so dass sich das Verdampferkörper-Kernteil 5 bei seiner Erwärmung schneller ausdehnt als das Verdampferkörper-Außenteil 3. Das Spiel zwischen dem Verdampferkörper-Kernteil 5 und der Begrenzungsfläche des Hohlraums 9 in Richtung senkrecht zur Abdampffläche ist hierbei so bemessen, dass das Verdampferkörper-Kernteil 5 bei Betriebstemperatur des Verdampferkörpers 1 mit der der Abdampffläche entgegengesetzten Begrenzungsfläche des Hohlraums 9 gerade spielfrei plan im Berührungskontakt ist (vgl. Figur 2). Jene Begrenzungsfläche bildet damit eine Wärmeaufnahmefläche des Verdampferkörper-Außenteils 3, über welche die Heizwärme des Verdampferkörper-Kernteils 5 via Wärmeleitung zu der Abdampffläche gelangt, um dort das Metall zu schmelzen/geschmolzen zu halten und abzudampfen.

Der Hohlraum 9 kann zum Beispiel mechanisch in dem Verdampferkörper-Außenteil 3 ausgeformt sein, beispielsweise durch Fräsen. Alternativ ist das Verdampferkörper-Außenteil 3 einfach auf das Verdampferkörper-Kernteil 5 aufgesintert, wobei die Materialstärken und Materialien derart gewählt sind, dass das Verdampferkörper-Kernteil 5 sich beim Abkühlen nach dem Sintern von dem Verdampferkörper-Außenteil 3 wegschrumpft, um so das erforderliche Spiel auszubilden.

Wie in den Figuren 4a und 4b gezeigt, kann gemäß der zweiten Ausführungsform das als z.B. Plattenkörper ausgebildete Verdampferkörper-Kernteil 5 sowohl bei Betriebstemperatur des Verdampferkörpers als auch darunter mit Spiel in dem inneren Hohlraum 9 aufgenommen sein. Mit anderen Worten ist gemäß dieser Ausführungsform das Verdampferkörper-Kernteil 5 sowohl vor als auch während des Betriebs des Verdampferkörpers 1 frei bewegbar in dem inneren Hohlraum 9 des Verdampferkörper-Außenteils 3 aufgenommen. Das heißt, das Verdampferkörper-Kernteil 5 ist wackelig in dem Verdampferkörper-Außenteil 3 aufgenommen und kann in alle Richtungen verschoben/bewegt werden. Das Verdampferkörper-Kernteil 5 wird also einfach führungsfrei/lose in den Hohlraum 9 hineingelegt, ohne das Anbringen einer Vorspannung, wie zum Beispiel mittels einer Feder. Bei dieser Alternative wird das Verdampferkörper-Außenteil 3 überwiegend durch Wärmestrahlung aufgeheizt, wobei sich gezeigt hat, dass bei den hohen Betriebstemperaturen von zum Beispiel 1700°C die Wärmeleitung eine untergeordnete Rolle spielt. Somit kann mit dem Verdampferkörper 1 gemäß dieser Ausführungsform ein sehr gutes Aufheiz- und Abdampfverhalten erzielt werden, wobei der Verdampferkörper 1 besonders einfach herzustellen ist und die Ausbildung von Rissen/Sprüngen aufgrund von unterschiedlichen Wärmedehnungseigenschaften von Kernteil 5 und Außenteil 3 ausgeschlossen ist.

In beiden Ausführungsformen kann das als Plattenkörper ausgebildete Verdampferkörper-Kernteil 5 eine konstante Plattendicke aufweisen, das heißt, als ebene Platte ausgebildet sein. Ferner kann das Verdampferkörper-Außenteil 5 in beiden Fällen als Rohrkörper mit geschlossener Mantelfläche ausgebildet sein. Dies bietet sich z.B. bei dem Verdampferkörper nach der zweiten Ausführungsform an, da hier der Wärmeübergang zwischen Kernteil 3 und Außenteil 5 überwiegend durch Wärmestrahlung erfolgt und durch die geschlossene Mantelfläche sichergestellt wird, dass der von dem Kernteil 5 abgestrahlte Wärmestrom nahezu vollständig auf das Verdampferkörper-Außenteil 3 übergeht und nicht ein Teil des Wärmestroms ungenutzt entweicht.

Das Verdampferkörper-Kernteil 5 des Verdampferkörpers 1 gemäß der ersten und der zweiten Ausführungsform wurde wie folgt hergestellt.

Zunächst wurde eine Pulvermischung aus leitfähigem TiB₂-Pulver, nicht leitfähigem Yttriumoxid-stabilisiertem ZrO₂-Pulver und Fe₂O₃-Pulver zubereitet. Alternativ oder zusätzlich zu dem Fe₂O₃-Pulver kann auch Fe₃O₄ und/oder Yttriumaluminat und/oder MgO*Al₂O₃ und/oder Al₂O₃ und/oder Aluminiumtitanat verwendet werden.

Das für die Pulvermischung verwendete TiB₂-Pulver wurde aus drei unterschiedlichen TiB₂-Pulvern mit jeweils unterschiedlicher mittlerer Korngröße d₅₀ zusammengemischt, so dass die resultierende TiB₂-Pulvermischung drei unterschiedliche Korngrößenfraktionen (fein, mittel, grob) aufwies. Der Einsatz dieser unterschiedlichen Korngrößenfraktionen bewirkt eine bleibende Restporosität (nach dem Sintern) von >20 Vol.-% bei zweckmäßiger Festigkeit des Kernteils. Weiterhin entsteht eine optimierte, grobe Porenstruktur, die ein verbessertes Temperaturwechselverhalten begünstigt.

Die Stabilisierung des ZrO₂'s durch Y₂O₃ schwächt den Volumensprung bei Modifikationsumwandlungen des ZrO₂'s. Die Stabilisierung des ZrO₂'s durch Y₂O₃ verbessert somit die Temperaturwechselbeständigkeit. ZrO₂ besitzt zwar eine geringfügige Sauerstoff-Ionenleitfähigkeit, diese ist allerdings im Vergleich zur nahezu metallischen Leitfähigkeit von TiB₂ vernachlässigbar. Deshalb wird hier ZrO₂ als nichtleitfähig angesehen.

Das Fe₂O₃ -Pulver dient zur Ausbildung einer Bindephase zwischen den TiB₂- und ZrO₂/Y₂O₃-Partikeln. Durch Einsatz von feinem Fe₂O₃-Pulver wird eine sehr gute Verteilung der Bindephase im Versatz - bei gleichzeitig geringem Masseanteil - gewährleistet.

Die exakte Zusammensetzung der Pulvermischung ist:

| | | |
|---|---|---|
| 92 ZrO₂/8 Y₂O₃ | (d₅₀=4-8µm) | 460 g |
| TiB₂, fein | (d₅₀= 4-8 µm) | 160 g |
| TiB₂, mittel | (d₅₀= 10-40 µm) | 170 g |
| TiB₂, grob | (d₅₀= 15-100 µm) | 200 g |
| Fe₂O₃-Pigment | (d₅₀<1µm) | 10 g |
| | Summe: | 1000 g |

Anschließend wurde die Pulvermischung zusammen mit 10g organischem Plastifizierungshilfsmittel (Zusoplast C92) in einem Intensivmischer trocken gemischt. Die trocken gemischte Pulvermischung wurde zusammen mit Wasser in einem Kneter geknetet und anschließend in einer Vakuumstrangpresse zu einem Strang mit Rechteckquerschnitt gezogen und auf eine Länge von 150 mm geschnitten.

Alternative Formgebungsverfahren zu dem oben beschriebenen plastischen Formgebungsverfahren sind:
- Schlickergießen
   Komplizierte Heizteile können durch den Einsatz von geeigneten Stell- und Verflüssigungsmitteln und Wasser im Schlickerguss gegossen werden.
- Trockenpressen
   Durch Trockenpressen von o.g. Pulvermischung können einfache Heizteile gepresst werden.
- Pressen einer Krümelmasse
   Durch Pressen einer sog. Krümelmasse, die neben den Pulvern auch einen geringfügigen Anteil an Wasser und organischem Bindemittel enthält lassen sich Heizelemente mit hoher Endporosität herstellen, da im allgemeinen niedrige Vorkompaktierungdrücke zur Herstellung der Grünkörper genügen.

Nach dem Formgebungsverfahren sollte der Grünling eine Gründichte von 40-60% der Dichte des Sinterkörpers haben.

Der wie oben beschrieben geformte Grünling wurde dann unter Schutzgas bei etwa 2000°C drucklos gesintert.

Je nach Bindephasenmenge kann ein eher harter (viel Bindephase) oder weicher (wenig Bindephase) Heizer hergestellt werden. Muss/Soll nachgearbeitet werden, so stellt dies bei Verwendung von wenig Bindephase in der Regel kein Problem dar.

Der derart hergestellte Widerstandsheizer bzw. das derart hergestellte Kernteil hat eine ausgezeichnete Hochtemperaturfestigkeit und Temperaturwechselbeständigkeit. Die Materialhärte und der spezifische elektrische Widerstand können z.B. durch geeignete Auswahl der Gewichtsanteile der eingesetzten Pulverkomponenten, der jeweiligen Korngrößenverteilung der eingesetzten Pulverkomponenten und der Prozessbedingungen wie Sinterdruck und Sintertemperatur sowie Grünlingsdichte an die jeweiligen Anforderungen angepasst werden. Der als Kernteil eingesetzte Widerstandsheizer verhält sich beim Einsatz im Verdampfungsprozess inert gegenüber dem umhüllenden Verdampferkörper, und das Kernteil verzeiht auch "überlaufendes Aluminium", d.h. es weist gegenüber flüssigem Aluminium eine ausreichende Beständigkeit auf. Zudem können mit dem beschriebenen Verfahren geometrisch komplizierte Widerstandsheizer einfach und effizient hergestellt werden. Insgesamt verfügt der neue Widerstandsheizer über ein breiteres Leistungsspektrum als die bislang bekannten Widerstandsheizer.

Durch die Verwendung des erfindungsgemäßen Widerstandsheizers als Kernteil in Kombination mit umhüllendem Verdampferkörper-Außenteil sowie gleichzeitiger Anwendung der in der WO 2006/029615 beschriebenen Schichtstruktur können spritzerfreie Schichten auf Kunststofffolien aufgebracht werden, wobei die maximal erreichbare Abdampfrate von Metall höher ist als bei bisherigen Verdampferschiffchen. Für Aluminium konnte die Spritzerbildung um den Faktor 10 verringert werden, bei sonst vergleichbaren Bedingungen. Mit Hilfe der Schichtstruktur sind aufgrund des "Schwammeffektes" des porösen Coatings auch breitere Verdampferkörper darstellbar, so dass gleichzeitig höhere Abdampfraten erzielt werden können.

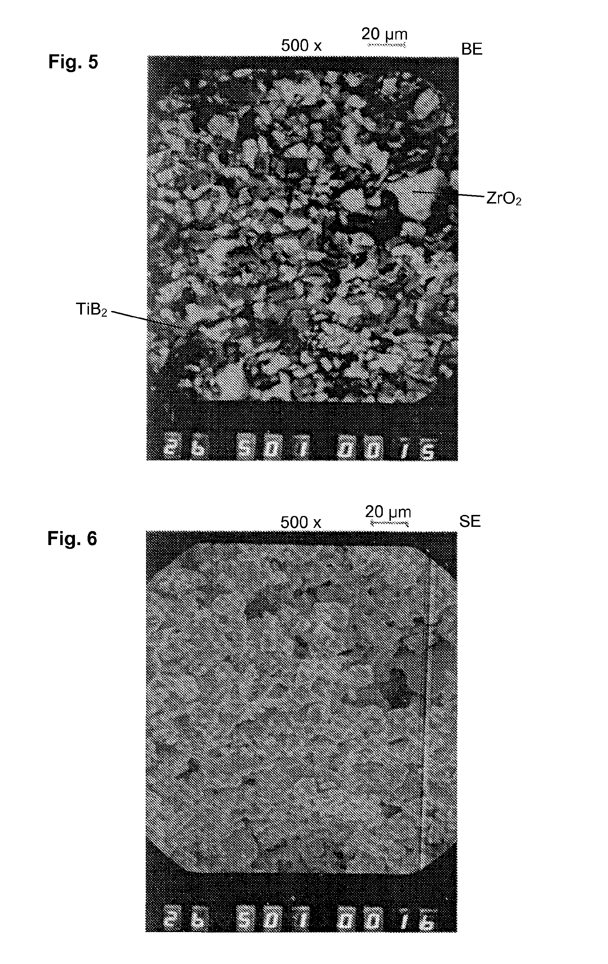

Die Figuren 5 bis 9 zeigen REM-Aufnahmen einer Bruchfläche eines erfindungsgemäßen Widerstandsheizers mit unterschiedlicher Vergrößerung (500x, 2000x, 5000x) und unterschiedlicher Aufnahmetechnik (BE und SE).

Die SE-Aufnahmen dienen hauptsächlich der Veranschaulichung des Porenraums bzw. der Porenstruktur. Die ZrO₂- und TiB₂-Partikel sowie die Bindephase sind bei den SE-Aufnahmen farblich nicht unterscheidbar (alle drei sind hellgrau). Der Porenraum ist schwarz, und hebt sich deutlich von der Feststofffarbe ab. Da es sich um eine zufällig entstandene Bruchfläche handelt zeigen die Aufnahmen auch Poren, die durch den Bruch selbst entstanden sind, so dass anhand dieser Aufnahmen keine quantitative Porenbestimmung möglich ist.

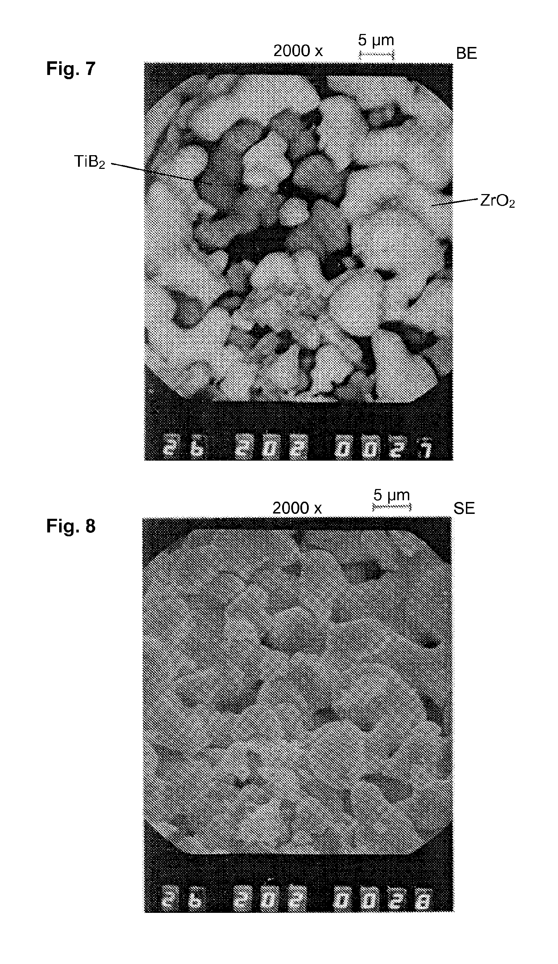

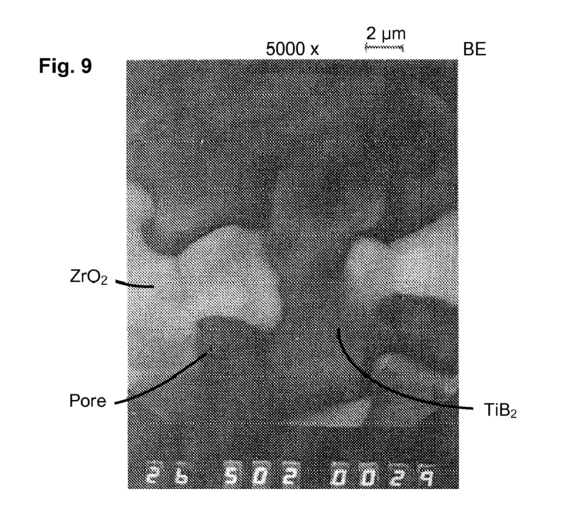

Die BE-Aufnahmen dienen hauptsächlich der Veranschaulichung des Verteilungsgrades (siehe Fig. 5) und des Versinterungsgrades (siehe Figuren 7 und 9) der ZrO₂- und TiB₂-Partikel. Die ZrO₂-Partikel sind hellgrau, die TiB₂-Partikel dunkelgrau und die Poren schwarz dargestellt. In den Figuren 7 und 9 sind die zwischen den ZrO₂-Partikeln und den TiB₂-Partikel jeweils untereinander ausgebildeten Sinterbrücken gut zu erkennen, d.h. die ZrO₂- und TiB₂-Partikel versintern jeweils reinrassig miteinander. Der Zusammenhalt zwischen ZrO₂- und TiB₂-Partikeln erfolgt überwiegend über die Bindephase - dies ist jedoch in den Aufnahmen nicht zu erkennen.

Gemäß einer weiteren Ausführungsform der Erfindung ist ein elektrisch leitfähiger Widerstandsheizer als Sinterkörper mit einer Gesamtporosität von größer gleich 20 Vol.-% ausgebildet, wobei der Widerstandsheizer durch druckloses Sintern eines Grünlings oder durch Sintern des Grünlings bei geringem Sinterdruck (max. 20 bar) hergestellt wird/herstellbar ist. Der Grünling ist aus einer Pulvermischung hergestellt, die eine körnige, elektrisch leitfähige Komponente, die aus der Gruppe ausgewählt ist, die aus Boriden, Nitriden und Carbiden von jeweils der IV., V. und VI. Nebengruppe sowie einer Mischung aus wenigstens zwei dieser Verbindungen besteht, ein körniges, hochschmelzendes Oxid, körniges Aluminiumnitrid und ein körniges, niedrigschmelzendes Oxid und/oder Borat aufweist. Die weiter oben gemachten Angaben z.B. hinsichtlich der Prozessbedingungen sowie der Art und Menge der eingesetzten Komponenten sind auch für diese Ausführungsform anwendbar, mit der Ausnahme, dass anstatt des körnigen hochschmelzenden Oxids eine Mischung aus einem hochschmelzenden Oxid und Aluminiumnitrid verwendet wird. Z.B. können 1 bis 25 Gew.-% (z.B. 5 bis 15 Gew.-%) AlN mit einer mittleren Korngröße von z.B. 0,5 bis 15 µm (z.B. 5 bis 12 µm) eingesetzt werden. Die exakte Struktur sowie die chemischen Komponenten eines derart hergestellten Widerstandsheizers konnten bislang nicht abschließend geklärt werden, wobei es scheint, dass das AlN mit einem oder mehreren von der elektrisch leitfähigen Komponente, dem hochschmelzenden Oxid und dem niedrigschmelzenden Oxid und/oder Borat reagiert.

## Patentansprüche

1. Elektrisch leitfähiger Widerstandsheizer, der als Sinterkörper mit einer Gesamtporosität von größer gleich 20 Vol.-% ausgebildet ist und eine Mischung aus
20-80 Gew.-% einer körnigen, elektrisch leitfähigen Komponente, die aus der Gruppe ausgewählt ist, die aus Boriden, Nitriden und Carbiden von jeweils der IV., V. und VI. Nebengruppe sowie einer Mischung aus wenigstens zwei dieser Verbindungen besteht, und
20-80 Gew.-% eines körnigen, hochschmelzenden Oxids in weniger als 5 Gew.-% eines niedrigschmelzenden Oxids und/oder Borats als Bindephase aufweist,
wobei die Ausgangskomponente der elektrisch leitfähigen Komponente und/oder die Ausgangskomponente des hochschmelzenden Oxids eine zumindest bimodale Pulver-Korngrößenverteilung mit zumindest einer Korngrößenfraktion mit einer mittleren Korngröße von größer gleich 15 µm aufweisen.

2. Elektrisch leitfähiger Widerstandsheizer, der als Sinterkörper mit einer Gesamtporosität von größer gleich 20 Vol.-% ausgebildet ist, herstellbar durch Sintern eines Grünlings aus einer Pulvermischung, wobei die Pulvermischung aufweist:
20-80 Gew.-% einer körnigen, elektrisch leitfähigen Komponente, die aus der Gruppe ausgewählt ist, die aus Boriden, Nitriden und Carbiden von jeweils der IV., V. und VI. Nebengruppe sowie einer Mischung aus wenigstens zwei dieser Verbindungen besteht,
20-80 Gew.-% einer Mischung aus einem körnigen, hochschmelzenden Oxid und körnigem Aluminiumnitrid und
weniger als 5 Gew.-% eines körnigen, niedrigschmelzenden Oxids und/oder Borats,
wobei der Grünling drucklos oder bei geringem Sinterdruck gesintert wird und die Ausgangskomponente der elektrisch leitfähigen Komponente und/oder die Mischung aus dem körnigen, hochschmelzenden Oxid und körnigem Aluminiumnitrid eine zumindest bimodale Pulver-Korngrößenverteilung mit zumindest einer Korngrößenfraktion mit einer mittleren Korngröße von größer gleich 15 µm aufweisen.

3. Widerstandsheizer nach einem der Ansprüche 1 bis 2, wobei das niedrigschmelzende Oxid und/oder Borat aus der Gruppe ausgewählt ist, die besteht aus:
(a) den Oxiden des Eisens, des Aluminiums, des Titans und des Siliziums sowie einer Mischung aus wenigstens zwei dieser Verbindungen,
(b) den Mischoxiden der unter (a) genannten Oxide mit Al₂O₃ und/oder Y₂O₃ und/oder MgO und/oder CaO,
(c) Kalziumborat sowie B₂O₃ in Verbindung mit zumindest einem der unter (a) und (b) genannten Oxide und Mischoxide und
(d) einer Mischung aus wenigstens zwei der unter (a) bis (c) genannten Verbindungen.

4. Widerstandsheizer nach einem der Ansprüche 1 und 3, aufweisend:
TiB₂-Partikel als elektrisch leitfähige Komponente und
Y₂O₃-stabilisierte ZrO₂-Partikel als hochschmelzendes Oxid,
wobei die Bindephase Fe₂O₃ und/oder Fe₃O₄ und/oder Yttriumaluminat und/oder MgO*Al₂O₃ und/oder Al₂O₃ und/oder Aluminiumtitanat und/oder eine Boratverbindung der genannten Verbindungen aufweist.

5. Widerstandsheizer nach einem der Ansprüche 1 bis 4, ausgebildet als Platten- oder Stabkörper.

6. Verwendung des Widerstandsheizers nach Anspruch 5 als Verdampferkörper-Kernteil, das in ein Verdampferkörper-Außenteil einsetzbar ist, welches aus einem elektrisch isolierenden Material hergestellt ist und einen inneren, durchgehenden Hohlraum zur Aufnahme des Verdampferkörper-Kernteils sowie eine Abdampffläche aufweist, von der aus ein darauf zugeführtes Metall verdampfbar ist.

7. Verdampferkörper für den Betrieb in einer PVD-Metallisierungsanlage, mit
einem Verdampferkörper-Außenteil, das aus einem elektrisch isolierenden Material hergestellt ist und einen inneren, durchgehenden Hohlraum mit einer Begrenzungswand hat, auf deren Außenseite eine Abdampffläche ausgebildet ist, von welcher aus ein darauf zugeführtes Metall verdampfbar ist, und
einem Verdampferkörper-Kernteil, das als Widerstandsheizer gemäß Anspruch 5 ausgebildet ist und in den inneren Hohlraum des Verdampferkörper-Außenteils einsetzbar ist.

8. Verfahren zum Herstellen eines porösen, elektrisch leitfähigen Widerstandsheizers, wobei bei dem Verfahren ein Grünling aus einer Pulvermischung aus mindestens drei unterschiedlichen Komponenten geformt und bei geringem Sinterdruck oder drucklos gesintert wird,
und wobei für die Pulvermischung verwendet werden:
20-80 Gew.-% einer körnigen, elektrisch leitfähigen Komponente, die aus der Gruppe ausgewählt ist, die aus Boriden, Nitriden und Carbiden von jeweils der IV., V. und VI. Nebengruppe sowie einer Mischung aus wenigstens zwei dieser Verbindungen besteht,
20-80 Gew.-% eines körnigen, hochschmelzenden Oxids oder 20-80 Gew.-% einer Mischung des körnigen, hochschmelzenden Oxids mit Aluminiumnitrid und
weniger als 5 Gew.-% eines körnigen, niedrigschmelzenden Oxids und/oder Borats,
und wobei das Mischungsverhältnis der unterschiedlichen Komponenten und/oder die Korngrößenverteilung der Pulvermischung und/oder die Grünlingsdichte derart eingestellt werden, dass nach dem Sinterprozess die Gesamtporosität des Widerstandsheizers größer gleich 20 Vol.-% ist,
und wobei für die elektrisch leitfähige Komponente und/oder das hochschmelzende Oxid bzw. die Mischung des hochschmelzenden Oxids mit Aluminiumnitrid ein Pulver verwendet wird, das eine zumindest bimodale Pulver-Korngrößenverteilung mit zumindest einer Korngrößenfraktion mit einer mittleren Korngröße von größer gleich 15 µm aufweist.

9. Verfahren nach Anspruch 8, wobei der Grünling in einem plastischen Formgebungsverfahren oder einem Schlickergießprozess oder einem Trockenpressprozess oder durch Pressen einer Krümelmasse, die neben der Pulvermischung Wasser und Bindemittel aufweist, geformt wird.

10. Verfahren nach Anspruch 8 oder 9, wobei die Grünlingsdichte auf 40 bis 60% der Dichte des gesinterten Widerstandsheizers eingestellt wird.

11. Verfahren nach einem der Ansprüche 8 bis 10, wobei das niedrigschmelzende Oxid und/oder Borat aus der Gruppe ausgewählt wird, die besteht aus:
(a) den Oxiden des Eisens, des Aluminiums, des Titans und des Siliziums sowie einer Mischung aus wenigstens zwei dieser Komponenten,
(b) den Mischoxiden der unter (a) genannten Oxide mit Al₂O₃ und/oder Y₂O₃ und/oder MgO und/oder CaO,
(c) Kalziumborat sowie B₂O₃ in Verbindung mit zumindest einem der unter (a) und (b) genannten Oxide und Mischoxide und
(d) einer Mischung aus wenigstens zwei der unter (a) bis (c) genannten Verbindungen.

12. Verfahren nach Anspruch 8, wobei für die Mischung 40-60 Gew.-% der elektrisch leitfähigen Komponente, 40-60 Gew.-% des hochschmelzenden Oxids und weniger als 3 Gew.-% des niedrigschmelzenden Oxids und/oder Borats verwendet wird.

13. Verfahren nach Anspruch 8, wobei für die elektrisch leitfähige Komponente und/oder das hochschmelzende Oxid ein Pulver verwendet wird, das eine trimodale Pulver-Korngrößenverteilung mit einer feinen Korngrößenfraktion mit einer durchschnittlichen Korngröße von 4-8 µm, einer mittleren Korngrößenfraktion mit einer durchschnittlichen Korngröße von 10-40 µm und einer groben Korngrößenfraktion mit einer durchschnittlichen Korngröße von 40-100 µm aufweist.

14. Verfahren nach einem der Ansprüche 8 bis 13, wobei für das niedrigschmelzende Oxid und/oder Borat ein feinkörniges Pulver verwendet wird, das eine mittlere Korngröße von kleiner als 5 µm, z.B. kleiner als 3 µm, z.B. kleiner als 1 µm, hat.

15. Verfahren nach einem der Ansprüche 8 bis 14, wobei für die Mischung
TiB₂-Pulver als elektrisch leitfähige Komponente,
Y₂O₃-stabilisiertes ZrO₂-Pulver als hochschmelzendes Oxid und
Fe₂O₃ und/oder Fe₃O₄ und/oder Yttriumaluminat und/oder MgO*Al₂O₃ und/oder Al₂O₃ und/oder Aluminiumtitanat als niedrigschmelzendes Oxid und/oder Borat verwendet wird.
